Europäisches Patentamt

European Patent Office

Office européen des brevets

(19)

(11) Veröffentlichungsnummer: **0 075 656**
B2

# (12) NEUE EUROPÄISCHE PATENTSCHRIFT

(45) Veröffentlichungstag der neuen Patentschrift:
07.01.88

(21) Anmeldenummer: 82105798.1

(22) Anmeldetag: 30.06.82

(51) Int. Cl.⁴: **H 02 H 3/087**, H 02 H 1/04

(54) Elektronische Überstromschutzvorrichtung.

(30) Priorität: 29.09.81 DE 3138645

(43) Veröffentlichungstag der Anmeldung:
06.04.83 Patentblatt 83/14

(45) Bekanntmachung des Hinweises auf die Patenterteilung:
26.03.86 Patentblatt 86/13

(45) Bekanntmachung des Hinweises auf die Entscheidung
über den Einspruch:
07.01.88 Patentblatt 88/1

(84) Benannte Vertragsstaaten:
DE FR GB IT SE

(56) Entgegenhaltungen:
DE - A - 2 539 911
DE - A - 3 034 927
FR - A - 2 341 973
US - A - 3 544 845
US - A - 3 809 955
US - A - 3 851 218

(73) Patentinhaber: Dr.Ing.h.c. F. Porsche
Aktiengesellschaft, Porschestrasse 42,
D-7000 Stuttgart 40 (DE)

(72) Erfinder: Lehmann, Ulrich, Friedhofstrasse 41,
D-7251 Weissach (DE)
Erfinder: Gabriel, Rudolf, Brennerstrasse 63,
D-7016 Gerlingen (DE)

EP 0 075 656 B2

## Beschreibung

Die Erfindung betrifft eine elektronische Überstromschutzvorrichtung mit einem als Widerstand geschalteten MOS-Transistor und einem elektronischen Schwellwertschalter.

Aus DE-A 2539 911 ist es bekannt, für einen Schwellwertschalter in integrierter MOS-Technik MOS-Transistoren zu verwenden, die als Widerstände geschaltet sind. Mit dieser Schaltung soll die Umschaltschwelle weitgehend unabhängig vom Wert der Schwellspannung der Schalttransistoren gemacht werden.

In DE-A 27 07 455 ist ein elektronischer Überstromauslöser mit einem in den Verbraucherkreis zwischen Stromquelle und Verbraucher geschalteten Schalter verbunden. Ein den Strom im Verbraucherstromkreis ermittelnder Messschalter steuert den als Transistor ausgebildeten Schalter im Verbraucherstromkreis an, sobald Überlastströme auftreten. Diese Schaltung ist recht aufwendig und bietet, da sie als integrierte Schaltung aufgebaut ist, nicht die Möglichkeit, weitere Mess- und Überwachungsfunktionen zu verwirklichen.

Demgegenüber besteht die Aufgabe der Erfindung darin, als Überstromschutzvorrichtung eine im Aufbau einfache und kostengünstige Schaltung zu schaffen.

Zur Lösung dieser Aufgabe sind erfindungsgemäss die im Kennzeichen des Anspruchs 1 angegebenen Merkmale vorgesehen. In dem aus dem Verbraucher und dem MOS-Transistor mit exakt linearer Kennlinie gebildeten Stromkreis teilt sich eine angelegte Spannung in die Spannung über dem Verbraucher und dem Spannungsabfall am Transistor auf, der als Messgrösse zur Ansteuerung eines Schwellwertschalters dient, der seinerseits über eine Treiberstufe den Gate-Eingang des MOS-Transistors steuert.

Der Schwellwertschalter ist dabei als Schmitt-Trigger-Kippstufe ausgebildet, die in bekannter Weise aus Transistoren oder IC-Gliedern aufgebaut ist.

In Ruhelage der Schaltung liegt die Betriebsspannung der Stromversorgung von z.B. + 12 V direkt an dem MOS-Transistor. Da die Auslösespannung bei ca. 1 V liegt, würde ohne zusätzliche Massnahmen die Betriebsspannung ein Inbetriebnehmen verhindern. Aus diesem Grunde und wegen der hohen Einschaltströme verschiedener Verbraucher ist dem Schwellwertschalter eine Verzögerungsschaltung vorgeschaltet, die den Eingang des Schwellwertschalters für eine bestimmte Dauer beim Einschalten der Schaltung sperrt und somit eine einstellbare Ansprechzeit für die Auslösung des Schwellwertschalters gewährleistet.

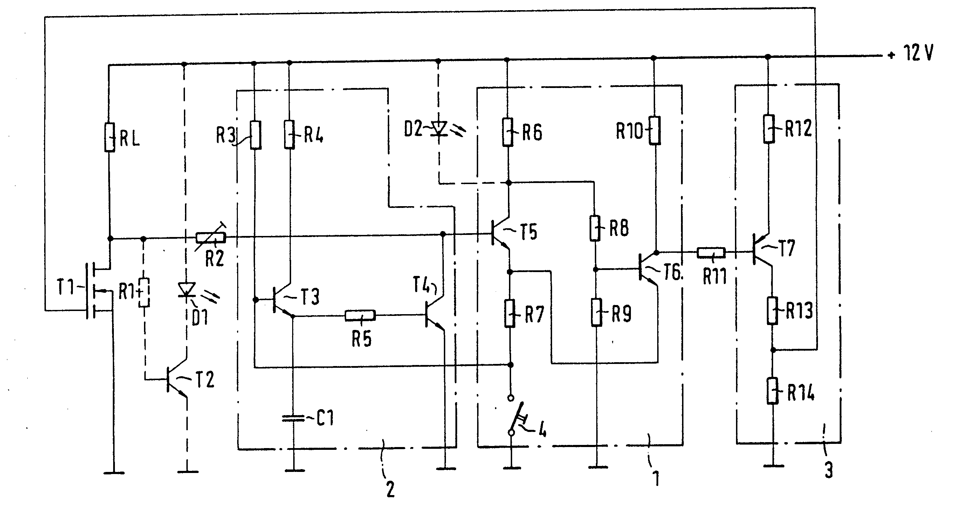

Die Schaltung der erfindungsgemässen elektronischen Überstromschutzvorrichtung ist in der Zeichnung dargestellt und wird nun näher erläutert.

An eine Leitung von einem Verbraucher RL, der an der Betriebsspannung 12 V liegt, zum Drain-Anschluss eines MOS-Transistors T1 ist ein Schwellwertschalter 1 über eine Verzögerungsschaltung 2 angeschlossen. Als Schwellwertschalter dient eine Schmitt-Trigger-Kippstufe mit den Transistoren T5 und T6, den Widerständen R6, R7, R8, R9, R10 sowie einem Druckschalter 4. Eine der Kippstufe über einen Widerstand R11 nachgeschaltete Treiberstufe 3 besteht aus dem Transistor T7 und den Widerständen R12, R13, R14. Sie dient der Signalumkehr und der Ansteuerung des MOS-Transistors T1.

Die Höhe des Schwellwertes ist an einem Widerstand R2 einstellbar, der zwischen der Basis des Transistors T5 und dem Verbindungspunkt zur Leitung vom Verbraucher RL zum MOS-Transistor T1 liegt. Die Anschlüsse der Verzögerungsschaltung am Schwellwertschalter liegen zwischen dem Widerstand R2 und der Basis von T5 sowie zwischen dem Widerstand R7 und dem Druckschalter 4. Die Verzögerungsschaltung besteht aus den Transistoren T3 und T4, einem zwischen ihnen eingesetzten Widerstand R5 sowie aus einem mitterseitig an T3 angeschlossenen Kondensator C1 und den Widerständen R3 und R4, von denen der eine dem Kollektor, der andere der Basis des Transistors T3 zugeordnet ist.

Beim Einschalten der Schaltung mit dem Druckschalter 4 wird der Transistor T5 mit Hilfe von T4 und T3 so lange gesperrt, bis die Einschaltstromspitzen des Verbrauchers RL abgeklungen sind. Die Ansprechzeitdauer bestimmt die Entladung des Kondensators C1, der über T3 an der Betriebsspannung liegt und ständig aufgeladen ist. Bei Betätigung des Druckschalters 4 wird der Transistor T3 gesperrt und somit entlädt sich C1 über R5 und hält T4 so lange leitend, bis seine Schwellspannung unterschritten wird. Dann erst kann der Schwellwertschalter gegebenenfalls durch Überströme ausgelöst werden.

Als Überwachung und Anzeige des Betriebsstromes dient ein aus einem Transistor T2, einer Leuchtdiode D1 und einem Widerstand R1 gebildeter Stromkreis. Mit dem Transistor T2, dessen Basis über den Widerstand R1 mit dem Drain-Anschluss des MOS-Transistors T1 in Verbindung steht, wird der Spannungsabfall von T1 gemessen, der die in die Kollektorzuleitung eingebaute Diode D1 zum Leuchten bringt. Die Leuchtstärke der Diode D1 wird durch Bemessung des Widerstandes R1 festgelegt.

Zum Anzeigen eines Überstromes ist eine Leuchtdiode D2 verwendet, die parallel zu R6 an der Betriebsspannung liegt und an den Kollektor von T5 angeschlossen ist. Die Überstromauslösung oder ein Kurzschluss lässt an T1 eine höhere Spannung entstehen. Wenn der Schwellwertschalter ausgelöst hat, liegt die Betriebsspannung an T1. In diesem Falle bleibt T5 ständig leitend, der Schwellwertschalter ist selbsthaltend und die Diode D2 leuchtet dauernd auf.

## Patentansprüche

1. Elektronische Überstromschutzvorrichtung, insbesondere für elektrische Anlagen von Kraftfahrzeugen, mit einem als Widerstand geschalteten MOS-Transistor (T1) und einem elektronischen Schwellwertschalter (1), gekennzeichnet durch die Merkmale:

a) der MOS-Transistor (T1), der einen dem Strom linear proportionalen Spannungsabfall aufweist, liegt in Reihe hinter dem Verbraucher (RL) an der Stromversorgung (+ 12 V),

b) der Schwellwertschalter (1) ist über eine Verzögerungsschaltung (2) an die Leitung vom Verbraucher (RL) zum MOS-Transistor (T1) angeschlossen, wobei die Verzögerungsschaltung (2) den Eingang des Schwellwertschalters (1) für eine bestimmte Dauer beim Einschalten der Schaltung sperrt,

c) der Schwellwertschalter steuert über eine Treiberstufe (3) den Gate-Eingang des MOS-Transistors (T1).

2. Vorrichtung nach Anspruch 1, dadurch gekennzeichnet, dass der Schwellwertschalter (1) als Schmitt-Trigger-Kippstufe ausgebildet ist, deren Ausgangssignal durch die Treiberstufe (3) umgekehrt wird.

3. Vorrichtung nach Anspruch 1 oder 2, dadurch gekennzeichnet, dass zur Betriebsstromanzeige ein Transistor (T2) mit kollektorseitig angeschlossener Leuchtdiode (D1) dient, wobei die Basis des Transistors (T2) mit der Drain-Elektrode des MOS-Transistors (T1) verbunden ist.

4. Vorrichtung nach einem der Ansprüche 1 bis 3, dadurch gekennzeichnet, dass der Schwellwertschalter (1) mittels zweier Transistoren (T5 und T6) aufgebaut ist, wobei ein Kollektor des Transistors (T5) über einen Widerstand (R6) an die Stromversorgung (+12V) angeschlossen ist und dem Widerstand (R6) eine Leuchtdiode (D2) parallel geschaltet ist, die zur Anzeige eines Überstroms bei Selbsthaltung des Schwellwertschalters (1) dient.

## Claims

1. Electronic overload protection device, in particular for electrical installations in motor vehicles, having an MOS transistor (T1) connected as a resistor and an electronic threshold value switch (1), characterised by the following features:

a) the MOS transistor (T1), which has a fall in voltage linearly proportional to the current, is connected in series downstream of the load (RL) to the current supply (+12 V),

b) the threshold value switch (1) is connected via a delay circuit (2) to the line from the load (RL) to the MOS transistor (T1), the delay circuit (2) cutting off the input of the threshold value switch (1) for a specific period of time when the circuit is switched on,

c) the threshold value switch controls the gate input of the MOS transistor (T1) via a driver (3).

2. Device according to claim 1, characterised in that the threshold value switch (1) is designed as a Schmitt trigger sweep stage, the output signals of which are inverted by the driver (3).

3. Device according to claim 1 or 2, characterised in that a transistor (T2) with a light-emitting diode (D1) connected on the collector side is used to indicate the operating current, the base of the transistor (T2) being connected to the drain electrode of the MOS transistor (T1).

4. Device according to any one of the claims 1 to 3, characterised in that the threshold value switch (1) is formed from two transistors (T5 and T6), a collector of the transistor (T5) being connected via a resistor (R6) to the current supply (+12 V) and a light-emitting diode (D2) connected in parallel with the resistor (R6) and used to indicate an overload when the threshold value switch (1) is triggered.

## Revendications

1. Dispositif de protection contre les surintensités électronique, destiné en particulier aux installations électriques de véhicules automobiles, comportant un transistor MOS (T1) monté en résistance et un interrupteur à seuil (1) électronique, caractérisé en ce que:

a) le transistor MOS (T1) qui présente une chute de tension linéairement proportionnelle à l'intensité, est relié, en série après le récepteur (RL), à l'alimentation (+12 V);

b) l'interrupteur à seuil (1) est branché, par l'intermédiaire d'un montage à retard (2) sur la ligne reliant le récepteur (RL) au transistor MOS (T1), le montage à retard (2) bloquant l'entrée de l'interrupteur à seuil (1) pendant une durée déterminée, lors de la fermeture du circuit;

c) l'interrupteur à seuil commande l'entrée de porte du transistor MOS (T1) par l'intermédiaire d'un étage d'attaque (3).

2. Dispositif selon la revendication 1, caractérisé en ce que l'interrupteur à seuil (1) est réalisé sous la forme d'un circuit de bascule de Schmitt dont le signal de sortie est inversé par l'étage d'attaque (3).

3. Dispositif selon la revendication 1 ou 2, caractérisé en ce que l'affichage de l'intensité de service est assuré par un transistor (T2) avec une diode électroluminescente (D1) branchée du côté collecteur, la base du transistor (T2) étant reliée à l'électrode de drain du transistor MOS (T1).

4. Dispositif selon l'une des revendications 1 à 3, caractérisé en ce que l'interrupteur à seuil (1) est réalisé au moyen de deux transistors (T5 et T6), un collecteur du transistor (T5) étant relié, par l'intermédiaire d'une résistance (R6), à l'alimentation (+12 V) et une diode électroluminescente (D2), servant à afficher une surintensité lorsque l'interrupteur à seuil (1) est dans l'état de maintien, étant montée en parallèle sur la résistance (R6).